# EUROPEAN PATENT APPLICATION

(11) **EP 4 632 006 A1**
(43) Date of publication of application: **15.10.2025**
(21) Application number: 23909851.0
(22) Date of filing: 27.11.2023
(51) Int. Cl.: C08L 69/00, C08L 55/02, C08L 25/12

(54) **POLYCARBONATE ALLOY MATERIAL WITH GOOD COLOR STABILITY, AND PREPARATION METHOD THEREFOR AND USE THEREOF**

(30) Priority: 30.12.2022 CN 202211738483
(71) Applicant: KINGFA SCI. & TECH. CO., LTD., Guangzhou, Guangdong 510663 (CN)
(72) Inventor: CEN, Yin, Guangzhou, Guangdong 510663 (CN); CHEN, Pingxu, Guangzhou, Guangdong 510663 (CN); AI, Junwei, Guangzhou, Guangdong 510663 (CN); DING, Chao, Guangzhou, Guangdong 510663 (CN); YE, Nanbiao, Guangzhou, Guangdong 510663 (CN); WANG, Peitao, Guangzhou, Guangdong 510663 (CN); TIAN, Zhengyu, Guangzhou, Guangdong 510663 (CN); DONG, Xiangmao, Guangzhou, Guangdong 510663 (CN); CHEN, Yongwen, Guangzhou, Guangdong 510663 (CN)
(74) Representative: Petraz, Gilberto Luigi
(86) International application number: PCT/CN2023/134338
(87) International publication number: WO 2024/139920

(57) **Abstract**

The present invention relates to a polycarbonate alloy material with good color stability, and a preparation method therefor and use thereof. The polycarbonate alloy material with good color stability includes the following components in parts by weight: 50-90 parts of polycarbonate, 1-20 parts of an acrylonitrile-butadiene-styrene copolymer, 5-20 parts of a flame retardant, 1-25 parts of a toughening agent, 0.1-2 parts of a stabilizer, and 0.1-5 parts of an anti-dripping agent. The polycarbonate alloy material not only has good thin-wall flame retardance, but also has a higher tensile strength retention rate after long-term thermo-oxidative aging, a browning problem is obviously improved, and a use scenario is wide.

## Description

### TECHNICAL FIELD

The present invention relates to the technical field of plastics, and more specifically relates to a polycarbonate alloy material with good color stability, and a preparation method therefor and use thereof.

### BACKGROUND

PC/ABS alloy materials are obtained by compounding polycarbonate and acrylonitrile-butadiene-styrene copolymers, which combine excellent characteristics of the two materials, including formability of the acrylonitrile-butadiene-styrene copolymers and mechanical properties, impact strength and temperature resistance of the polycarbonate, and can be widely used in internal parts of automobiles, business machines, communication equipment, household appliances and lighting equipment.

Since the PC/ABS alloy materials contain a PB phase and an alkene structure of the PB phase is prone to undergoing a thermo-oxidative aging reaction under the action of heat and oxygen and has a self-catalytic effect, the materials have more severe color browning with increase in the aging time. Not only are application ranges of some materials applied to external parts affected due to an appearance problem, but also the more severe browning represents that the heat and the oxygen have a greater effect on the materials, thermo-oxidative degradation of resins is further accelerated, and the mechanical properties are rapidly decreased. These are defects of the PC/ABS alloy materials used in a high-temperature environment (90-130°C). In addition, obvious decrease in tensile strength of the PC/ABS alloy materials in the high-temperature environment also affects the use.

A Chinese patent titled "PC/ABS Material Composition Capable of Improving Yellowing" studies a chromatic aberration problem of a PC/ABS material composition under light conditions, which does not concern the problems of color browning of the material in the high-temperature environment and decrease in tensile strength of the material.

Thus, it is necessary to solve the problems that the PC/ABS alloy materials are prone to color browning in the high-temperature environment and have obviously decreased tensile strength (a retention rate is lower than 50%).

### SUMMARY

A primary objective of the present invention is to overcome the above problems that existing PC/ABS alloy materials are prone to color browning in a high-temperature environment and have obviously decreased tensile strength, and to provide a polycarbonate alloy material with good color stability. The polycarbonate alloy material not only has good thin-wall flame retardance, but also has a higher tensile strength retention rate after long-term thermo-oxidative aging, a browning problem is obviously improved, and a use scenario is wide.

A further objective of the present invention is to provide a method for preparing the above polycarbonate alloy material.

A further objective of the present invention is to provide use of the above polycarbonate alloy material in preparation of a photovoltaic energy product.

The above objectives of the present invention are achieved through the following technical solutions.

A polycarbonate alloy material with good color stability includes the following components in parts by weight:
50-90 parts of polycarbonate,
1-20 parts of an acrylonitrile-butadiene-styrene copolymer,
5-20 parts of a flame retardant,
1-25 parts of a toughening agent,
0.1-2 parts of a stabilizer, and
0.1-5 parts of an anti-dripping agent,
wherein the toughening agent is a core-shell structured toughening agent, a ratio of a shell thickness to a core diameter of the core-shell structured toughening agent is 1:(5-30), a core of the core-shell structured toughening agent is polydimethylsiloxane and acrylate, and a silicon content of the core-shell structured toughening agent is 8-80 wt%.

The inventor of the present invention finds through several studies that the addition of the specific toughening agent into the material with the polycarbonate and the acrylonitrile-butadiene-styrene copolymer as a matrix resin can not only improve a tensile strength retention rate of the polycarbonate alloy material after long-term thermo-oxidative aging, but also can improve a browning problem of the polycarbonate alloy material after long-term thermo-oxidative aging. The reason is that by regulating the ratio of the shell thickness to the core diameter of the toughening agent within a certain range, the compatibility between the toughening agent and the matrix resin can be improved. On the one hand, a stable structure is formed by the good compatibility, thereby improving the tensile strength retention rate of the polycarbonate alloy material after the long-term thermo-oxidative aging; and on the other hand, silicone rubber composed of the polydimethylsiloxane and the acrylate has excellent color stability during the thermo-oxidative aging. The good compatibility is conducive to distribution of the toughening agent, and the silicon content of the toughening agent is further regulated, so that the color browning problem of the polycarbonate alloy material after the long-term thermo-oxidative aging can be obviously improved.

In addition, the polycarbonate alloy material also has good thin-wall flame retardance.

That is, the polycarbonate alloy material of the present invention not only has the good thin-wall flame retardance, but also has the higher tensile strength retention rate after the long-term thermo-oxidative aging, the browning problem is obviously improved, and the application scenario is wide.

Preferably, the polycarbonate alloy material includes the following components in parts by weight:
60-85 parts of the polycarbonate,
3-10 parts of the acrylonitrile-butadiene-styrene copolymer,
7-10 parts of the flame retardant,
3-10 parts of the toughening agent,
0.25-1.2 parts of the stabilizer, and
0.3-0.8 part of the anti-dripping agent.

Preferably, the ratio of the shell thickness to the core diameter of the core-shell structured toughening agent is 1:(6-25).

Preferably, the silicon content of the core-shell structured toughening agent is 30-80 wt%.

Preferably, a shell of the core-shell structured toughening agent is acrylate.

The acrylonitrile-butadiene-styrene copolymer, the polycarbonate, the stabilizer, the flame retardant and the anti-dripping agent that are commonly used in the art can all be used in the present invention.

Preferably, the acrylonitrile-butadiene-styrene copolymer is obtained by a bulk polymerization method.

Preferably, an average molecular weight of the polycarbonate is 21,000-33,650.

Preferably, the stabilizer is composed of a metal passivator, a hindered phenol antioxidant and a glycidyl methacrylate grafted styrene-acrylonitrile copolymer at a mass ratio of 1:(1-3):(1-8).

The introduction of the glycidyl methacrylate grafted styrene-acrylonitrile copolymer further enhances dispersion of the toughening agent and ABS, which is more conducive to distribution of the toughening agent in the matrix resin. On this basis, due to the existence of a GMA active functional group, end-capping of a PC resin can be conducted, thereby decreasing the generation rate and content of a quinone chromogenic group in a thermo-oxidative reaction of the PC and improving the performance stability after aging. Meanwhile, an effect of improving the color stability of a double bond in the ABS is achieved, thereby inhibiting the thermo-oxidative reaction rate of the double bond. The metal passivator weakens an inevitable catalytic effect of metal impurities in raw materials during processing and use on the material, thereby slowing down a thermo-oxidative degradation reaction. The hindered phenol antioxidant can capture peroxide free radicals. Through a synergistic effect of the three, namely the metal passivator, the hindered phenol antioxidant and the glycidyl methacrylate grafted styrene-acrylonitrile copolymer, not only is a stabilizing effect of the stabilizer further enhanced, but also the thermo-oxidative aging reaction rate of the material is further slowed down.

Optionally, the metal passivator is at least one of an organic acid or thiobisphenol phosphite, and melamine.

Further optionally, the organic acid is citric acid.

Optionally, the hindered phenol antioxidant is at least one of antioxidant 1010, antioxidant 1098, or antioxidant 1076.

Optionally, the flame retardant includes, but is not limited to, a phosphorus based flame retardant; and the phosphorus based flame retardant includes, but is not limited to, TPP, BDP, RDP, or RDX, etc.

Optionally, the anti-dripping agent includes, but is not limited to, a fluoropolymer; and the fluoropolymer includes, but is not limited to, SAN coated PTFE, MMA coated PTFE, organosilicone coated PTFE, PTFE pure powder, or a PTFE emulsion, etc.

In order to obtain performance in other aspects, 0.5-8 parts of other auxiliary agents can also be added into the polycarbonate alloy material of the present invention.

Optionally, the other auxiliary agents are at least one of a filler or a lubricant. Preferably, the filler is at least one of a glass fiber or a mineral filler. Preferably, the lubricant is at least one of stearate or oxidized polyolefin wax.

A method for preparing the above polycarbonate alloy material includes the following steps: mixing the respective components, conducting melt extrusion, and conducting granulation to obtain the polycarbonate alloy material.

More preferably, a rotation speed of stirring and mixing is 30-80 rpm/min; and a twin-screw extruder has a length-diameter ratio of (35-60): 1, a screw cylinder temperature of 220-260°C and a screw rod rotation speed of 200-800 rpm/min.

Use of the above polycarbonate alloy material in preparation of a photovoltaic energy product also falls in the scope of protection of the present invention.

Preferably, the photovoltaic energy product is a photovoltaic inverter module or an energy storage module.

Compared with the prior art, the present invention has the following beneficial effects:
The polycarbonate alloy material of the present invention not only has the good thin-wall flame retardance, but also has the higher tensile strength retention rate after the long-term thermo-oxidative aging, the browning problem is obviously improved, and the application scenario is wide.

### DETAILED DESCRIPTION OF EMBODIMENTS

To describe the technical solutions of the present invention more clearly and completely, the present invention is further described in detail through specific examples below. It is understandable that the specific examples described herein are only used to explain the present invention and are not used to limit the present invention, and various changes can be made within the scope limited by the claims of the present invention.

Some of the reagents used in respective examples and comparative examples of the present invention are described as follows:
polycarbonate 1#: PC-10NP, LG, South Korea, with an average molecular weight of 24,500;
polycarbonate 2#: 7030PJ, Samyang, South Korea, with an average molecular weight of 33,650;
polycarbonate 3#: PC-22NP, LG, South Korea, with an average molecular weight of 21,000;
polycarbonate 4#: FN1500, Idemitsu, Japan, with an average molecular weight of 14,300;
acrylonitrile-butadiene-styrene copolymer 1#: obtained by a bulk polymerization method, with an average molecular weight of 17,000 and an acrylonitrile content of 28%, commercially available;
acrylonitrile-butadiene-styrene copolymer 2#: obtained by a suspension polymerization method, with an average molecular weight of 17,000 and an acrylonitrile content of 28%, commercially available;
toughening agent 1#: core-shell toughening agent, with a ratio of a shell thickness to a core diameter being 1:6, adopting silicone rubber as a core component and acrylate as a shell, with a silicone content of 30 wt%, S-2130, Mitsubishi Chemical;
toughening agent 2#: core-shell toughening agent, with a ratio of a shell thickness to a core diameter being 1:5, adopting silicone rubber as a core component and acrylate as a shell, with a silicone content of 10 wt%, S-2006, Mitsubishi Chemical;
toughening agent 3#: core-shell toughening agent, with a ratio of a shell thickness to a core diameter being 1:30, adopting silicone rubber as a core component and acrylate as a shell, with a silicone content of 80 wt%, SX005, Mitsubishi Chemical;
toughening agent 4#: core-shell toughening agent, with a ratio of a shell thickness to a core diameter being 1:8, adopting silicone rubber as a core component and acrylate as a shell, with a silicone content of 8 wt%, S-2001, Mitsubishi Chemical;
toughening agent 5#: core-shell toughening agent, with a ratio of a shell thickness to a core diameter being 1:25, adopting silicone rubber as a core component and acrylate as a shell, with a silicone content of 80 wt%, SX005, Mitsubishi Chemical;
toughening agent 6#: core-shell toughening agent, with a ratio of a shell thickness to a core diameter being 1:8, adopting silicone rubber as a core component and SAN as a shell, with a silicone content of 8 wt%, S2260, Mitsubishi Chemical;
toughening agent 7#: core-shell toughening agent, with a ratio of a shell thickness to a core diameter being 1:4, adopting silicone rubber as a core component and acrylate as a shell, with a silicone content of 8 wt%, S-2501, Mitsubishi Chemical;
toughening agent 8#: core-shell toughening agent, with a ratio of a shell thickness to a core diameter being 1:6, adopting silicone rubber as a core component and acrylate as a shell, with a silicone content of 85 wt%, MR01, Kaneka, Japan;
toughening agent 9#: core-shell toughening agent, adopting acrylate as a core component and acrylate as a shell, with a silicone content of 0 wt%, EXL2330, Dow Chemical;
toughening agent 10#: non-core-shell toughening agent, EMA 1125, Dupont;
stabilizer 1#: citric acid, commercially available;
stabilizer 2#: antioxidant 1010, commercially available;
stabilizer 3#: glycidyl methacrylate grafted styrene-acrylonitrile copolymer, S0G-002, Yijiarong;
stabilizer A#: obtained by mixing the stabilizer 1#, the stabilizer 2# and the stabilizer 3# at a weight ratio of 1:2:5;
stabilizer B#: obtained by mixing the stabilizer 1#, the stabilizer 2# and the stabilizer 3# at a weight ratio of 1:1:1;
stabilizer C#: obtained by mixing the stabilizer 1#, the stabilizer 2# and the stabilizer 3# at a weight ratio of 1:3:8;
flame retardant 1#: BDP, Adeka, Japan;
flame retardant 2#: PX-200, Daihachi, Japan;
anti-dripping agent: FP-100, Fushimi, Japan;
other auxiliary agents: lubricant, stearate, commercially available.

Unless otherwise specified, components (e.g., the anti-dripping agent and the other auxiliary agents) selected in respective parallel examples and comparative examples are identical commercially available products.

Properties of polycarbonate alloy materials provided in respective examples and comparative examples of the present invention are tested according to the following test methods.

Tensile strength and retention rate: According to ASTM D638-2017, test sample strips were prepared by an injection molding process or a hot pressing process according to requirements of TYPE I; 5 prepared sample strips were placed in a constant-temperature and constant-humidity regulator with a temperature of 25°C and a humidity of 50% for 40-72 hours and then tested at a test speed of 50 mm/min and a maximum load of 10 KN, and a mean tensile strength at break of the 5 sample strips was calculated as an initial tensile strength; the sample strips were placed in a constant-temperature oven at 130°C for a fixed aging time, taken out, placed in a constant-temperature and constant-humidity regulator with a temperature of 25°C and a humidity of 50% for 40-72 hours and then tested at a test speed of 50 mm/min and a maximum load of 10 KN, and a mean tensile strength at break of the 5 sample strips after aging was calculated as a tensile strength after aging; and the tensile strength retention rate was obtained by calculation.

Chromatic aberration: A test was carried out using a colorimeter. A sample plate with a thickness of 2.0 mm, a width of 60 mm and a length of 60 mm was prepared by injection molding; 5 prepared sample strips were placed in a constant-temperature and constant-humidity regulator with a temperature of 25°C and a humidity of 50% for 40-72 hours and then tested by the colorimeter (with an instrument model and a light source) to obtain an initial chromatic aberration value; the sample strips were placed in a constant-temperature oven at 130°C for a fixed aging time, taken out, placed in a constant-temperature and constant-humidity regulator with a temperature of 25°C and a humidity of 50% for 40-72 hours and then tested in 5 different areas on a same test plate, respectively; and the chromatic aberration was obtained by calculation.

Flame retardance: A flammability test was carried out in accordance with the regulation of "Flammability Test of Plastic Materials, UL94". The vertical combustion grade of flame retardance was determined based on a combustion rate, an extinguishing time, an ability to resist dropping, and whether a dropping was burning. Samples used for testing: A length was 125 mm, a width was 13 mm, and a thickness was selected as 1.5 mm during the test in the present invention. According to the UL94 regulation, flame retardant grades of materials can be classified as UL94-HB, V0, V1, and V2.

Fluidity: The fluidity was expressed as a melt flow rate. According to requirements of ASTM D1238-2018, a load was selected as 5 kg, and a test temperature was 245°C.

A preparation process of the polycarbonate alloy materials in respective examples and comparative examples of the present invention is as follows: after weighing respective components according to a proportion, adding the same into a high-speed mixer for stirring and blending to obtain a premix, and then conducting extrusion in a twin-screw extruder, followed by a melt granulation process to obtain the polycarbonate alloy materials. A rotation speed of the stirring was 50 rpm/min, and the twin-screw extruder had a length-diameter ratio of 48: 1, a screw cylinder temperature of 220°C and a screw rod rotation speed of 350 rpm/min.

### Examples 1-21

Examples 1-21 provide a series of polycarbonate alloy materials, with formulas shown in Table 1 and Table 2.

**Table 1 Formulas in Examples 1-11 (parts by weight)**

| | Example | | | | | | | | | | |
|---|---|---|---|---|---|---|---|---|---|---|---|
| | 1 | 2 | 3 | 4 | 5 | 6 | 7 | 8 | 9 | 10 | 11 |
| Polycarbonate 1# | 70 | 50 | 90 | 60 | 85 | 70 | / | / | / | 70 | 70 |
| Polycarbonate 2# | / | / | / | / | / | / | 70 | / | / | / | / |
| Polycarbonate 3# | / | / | / | / | / | / | / | 70 | / | / | / |
| Polycarbonate 4# | / | / | / | / | / | / | / | | 70 | / | / |
| Acrylonitrile-butadien e-styrene copolymer 1# | 5 | 20 | 1 | 10 | 3 | 5 | 5 | 5 | 5 | / | 5 |
| Acrylonitrile-butadien e-styrene copolymer 2# | / | / | / | / | / | / | / | / | / | 5 | / |
| Toughening agent 1# | 5 | 25 | 1 | 10 | 3 | 5 | 5 | 5 | 5 | 5 | 5 |
| Stabilizer A# | 0.5 | 2 | 0.1 | 1.2 | 0.25 | 0.5 | 0.5 | 0.5 | 0.5 | 0.5 | 0.5 |
| Flame retardant 1# | 9 | 20 | 5 | 10 | 7 | 9 | 9 | 9 | 9 | 9 | / |
| Flame retardant 2# | / | / | / | / | / | / | / | / | / | / | 9 |
| Anti-dripping agent | 0.5 | 5 | 0.1 | 0.8 | 0.3 | 0.5 | 0.5 | 0.5 | 0.5 | 0.5 | 0.5 |
| Other auxiliary agents | 0 | 0 | 0 | 0 | 0 | 2 | 0 | 0 | 0 | 0 | 0 |

**Table 2 Formulas in Examples 12-21 (parts by weight)**

| | Example | | | | | | | | | |
|---|---|---|---|---|---|---|---|---|---|---|
| | 12 | 13 | 14 | 15 | 16 | 17 | 18 | 19 | 20 | 21 |
| Polycarbonate 1# | 70 | 70 | 70 | 70 | 70 | 70 | 70 | 70 | 70 | 70 |
| Acrylonitrile-butadien e-styrene copolymer 1# | 5 | 5 | 5 | 5 | 5 | 5 | 5 | 5 | 5 | 5 |
| Toughening agent 1# | / | / | / | / | / | 5 | 5 | 5 | 5 | 5 |
| Toughening agent 2# | 5 | / | / | / | / | / | / | / | / | / |
| Toughening agent 3# | / | 5 | | / | / | / | / | / | / | / |
| Toughening agent 4# | / | / | 5 | / | / | / | / | / | / | / |
| Toughening agent 5# | / | / | / | 5 | / | / | / | / | / | / |
| Toughening agent 6# | / | / | / | / | 5 | / | / | / | / | / |
| Stabilizer A# | 0.5 | 0.5 | 0.5 | 0.5 | 0.5 | / | / | / | / | / |
| Stabilizer B# | / | / | / | / | / | 0.5 | / | / | / | / |
| Stabilizer C# | / | / | / | / | / | / | 0.5 | / | / | / |
| Stabilizer 1# | / | / | / | / | / | / | / | 0.5 | / | / |
| Stabilizer 2# | / | / | / | / | / | / | / | / | 0.5 | / |
| Stabilizer 3# | / | / | / | / | / | / | / | / | / | 0.5 |
| Flame retardant 1# | 9 | 9 | 9 | 9 | 9 | 9 | 9 | 9 | 9 | 9 |
| Anti-dripping agent | 0.5 | 0.5 | 0.5 | 0.5 | 0.5 | 0.5 | 0.5 | 0.5 | 0.5 | 0.5 |

### Comparative Example 1

The present comparative example provides a polycarbonate alloy material, with a formula different from that in Example 1: the toughening agent 1# was changed into an equivalent amount of the toughening agent 7#.

### Comparative Example 2

The present comparative example provides a polycarbonate alloy material, with a formula different from that in Example 1: the toughening agent 1# was changed into an equivalent amount of the toughening agent 8#.

### Comparative Example 3

The present comparative example provides a polycarbonate alloy material, with a formula different from that in Example 1: the toughening agent 1# was changed into an equivalent amount of the toughening agent 9#.

### Comparative Example 4

The present comparative example provides a polycarbonate alloy material, with a formula different from that in Example 1: the toughening agent 1# was changed into an equivalent amount of the toughening agent 10#.

### Comparative Example 5

The present comparative example provides a polycarbonate alloy material, with a formula different from that in Example 1: the toughening agent 1# was not added.

The properties of the polycarbonate alloy materials in respective examples and comparative examples were tested according to the above-mentioned test methods. Test results are shown in Table 3.

**Table 3 Property test results of polycarbonate alloy materials in respective examples and comparative examples**

| Test result | Flame retardance | Melt flow rate/g/10 min | Tensile strength (MPa) | Aging tensile strength retention rate/% | Chromatic aberration |
|---|---|---|---|---|---|
| Example 1 | V-0 | 18.7 | 63.2 | 123 | 0.3 |
| Example 2 | V-0 | 16.3 | 54.6 | 98 | 3.2 |
| Example 3 | V-0 | 15.1 | 61.3 | 118 | 1.8 |
| Example 4 | V-0 | 15.7 | 59.3 | 114 | 1.6 |
| Example 5 | V-0 | 17.3 | 60.9 | 103 | 1.3 |
| Example 6 | V-0 | 15.8 | 64.2 | 117 | 0.4 |
| Example 7 | V-0 | 27.8 | 62.8 | 104 | 0.6 |
| Example 8 | V-0 | 67.2 | 57.9 | 78 | 3.2 |
| Example 9 | V-0 | 49.2 | 50.8 | 65 | 4.7 |
| Example 10 | V-0 | 16.7 | 60.9 | 118 | 0.5 |
| Example 11 | V-0 | 19.1 | 57.1 | 98 | 1.1 |
| Example 12 | V-0 | 19.1 | 65.1 | 108 | 1.1 |
| Example 13 | V-0 | 18.2 | 64.5 | 113 | 0.9 |
| Example 14 | V-0 | 19.1 | 58.5 | 110 | 0.9 |
| Example 15 | V-0 | 15.7 | 54.2 | 118 | 0.4 |
| Example 16 | V-0 | 22.7 | 60.9 | 93 | 1.3 |
| Example 17 | V-0 | 20.3 | 63.2 | 108 | 1.7 |
| Example 18 | V-0 | 16.1 | 67.2 | 118 | 0.5 |
| Example 19 | V-0 | 17.7 | 60.2 | 82 | 31 |
| Example 20 | V-0 | 15.8 | 65.2 | 92 | 4.2 |
| Example 21 | V-0 | 16.5 | 59.2 | 86 | 2.3 |
| Comparative Example 1 | V-1 | 14.8 | 51.2 | 43 | 4.2 |
| Comparative Example 2 | V1 | 13.4 | 57.7 | 38 | 23.5 |
| Comparative Example 3 | HB | 23.7 | 48.2 | 31 | 8.9 |
| Comparative Example 4 | V0 | 22.1 | 52.1 | 22 | 5.3 |
| Comparative Example 5 | V0 | 20.1 | 72.1 | 43 | 10.3 |

It can be known from Table 3 that the polycarbonate alloy materials in Examples 1-21 have good flame retardance (V-0 grade) and higher tensile strength retention rates (greater than 50%) after long-term thermo-oxidative aging, and a browning problem is obviously improved (chromatic aberrations are less than 5).

It can be known from Examples 1-5 that use amounts of the respective components have certain impacts on the tensile strength, the tensile strength after long-term thermo-oxidative aging and the chromatic aberration, wherein the use amount of the polycarbonate is higher in Examples 1, 3, 4 and 5, and the polycarbonate undergoes Fries rearrangement under the combined action of heat and oxygen during the thermo-oxidative aging, leading to increase of a content of a cross-linked structure. Thus, the case that the aging tensile strength retention rate is higher than 100% occurs. Under comprehensive regulation of the respective components, the aging tensile strength retention rate in Example 1 is the highest, and the color aberration is the smallest. The color aberrations in Example 4 and Example 5 are both smaller than those in Example 2 and Example 3, and the browning problem is more obviously improved (the chromatic aberrations are smaller).

It can be known from Examples 1 and 7-9 that when the average molecular weight of the polycarbonate is within an appropriate range (21,000-33,650), the compatibility between the toughening agent and the matrix resin can be further improved, the aging tensile strength retention rates of the polycarbonate alloy materials are higher, and the browning problem is more obviously improved (the chromatic aberrations are smaller).

It can be known from Examples 1 and 10 that when the acrylonitrile-butadiene-styrene copolymer synthesized by the bulk polymerization method is adopted, the acrylonitrile-butadiene-styrene copolymer obtained by the bulk polymerization method has a more appropriate rubber content and better compatibility with the toughening agent, and a structure formed by the toughening agent and the matrix resin is stabler, so that the aging tensile strength retention rate of the obtained polycarbonate alloy material is higher, and the browning problem is more obviously improved (the chromatic aberration is smaller).

It can be known from Examples 1 and 11 that when the specific phosphorus based flame retardant is adopted, the aging tensile strength retention rate of the obtained polycarbonate alloy material can be higher, and the browning problem is more obviously improved (the chromatic aberration is smaller).

It can be known from Examples 1 and 12-16 that when the ratio of the shell thickness to the core diameter is 1:(6-30) and the shell is acrylate (Examples 1, 13, 14 and 15), the aging tensile strength retention rates of the polycarbonate alloy materials are higher, and the browning problem is more obviously improved (the chromatic aberrations are smaller).

It can be known from Examples 1, 12, 13 and 15 that when the ratio of the shell thickness to the core diameter is 1:(6-30) and the silicon content of the core-shell structured toughening agent is 30-80 wt% (Examples 1, 13 and 15), the aging tensile strength retention rates of the polycarbonate alloy materials are higher.

It can be known from Examples 1 and 17-21 that when the composite stabilizer is selected (Examples 1, 17 and 18), the aging tensile strength retention rates of the polycarbonate alloy materials are higher, and the browning problem is more obviously improved (the chromatic aberrations are smaller).

In Comparative Example 1, the ratio of the shell thickness to the core diameter of the toughening agent added is too large, and the tensile strength of the polycarbonate alloy material is obviously decreased after long-term thermo-oxidative aging (the retention rate is less than 50%). In Comparative Example 2, the silicon content of the toughening agent added is too high, the tensile strength of the polycarbonate alloy material is obviously decreased after long-term thermo-oxidative aging (the retention rate is less than 50%), and the browning problem is not better improved (the color difference is greater than 5). In Comparative Examples 3 and 4, the toughening agents added are inappropriate, the tensile strength of the polycarbonate alloy materials is obviously decreased after long-term thermo-oxidative aging (the retention rates are less than 50%), and the browning problem is not better improved (the color differences are greater than 5). In Comparative Example 5, the toughening agent is not added, the tensile strength of the polycarbonate alloy material is obviously decreased after long-term thermo-oxidative aging (the retention rate is less than 50%), and the browning problem is not better improved (the color difference is greater than 5).

Obviously, the above examples of the present invention are only instances for clearly illustrating the present invention and are not limitations of the embodiments of the present invention. For those of ordinary skill in the art, other changes or alternations in different forms can also be made on the basis of the above description. It is not necessary and possible to list all of the embodiments herein. Any modifications, equivalent substitutions, improvements and the like made within the spirit and principles of the present invention shall be included in the scope of protection of the claims of the present invention.

## Claims

1. A polycarbonate alloy material with good color stability, comprising the following components in parts by weight:
50-90 parts of polycarbonate,
1-20 parts of an acrylonitrile-butadiene-styrene copolymer,
5-20 parts of a flame retardant,
1-25 parts of a toughening agent,
0.1-2 parts of a stabilizer, and
0.1-5 parts of an anti-dripping agent,
wherein the toughening agent is a core-shell structured toughening agent, a ratio of a shell thickness to a core diameter of the core-shell structured toughening agent is 1:(5-30), a core of the core-shell structured toughening agent is silicon rubber, and a silicon content of the core-shell structured toughening agent is 8-80 wt%.

2. The polycarbonate alloy material according to claim 1, wherein the polycarbonate alloy material comprises the following components in parts by weight:
60-85 parts of the polycarbonate,
3-10 parts of the acrylonitrile-butadiene-styrene copolymer,
7-10 parts of the flame retardant,
3-10 parts of the toughening agent,
0.25-1.2 parts of the stabilizer, and
0.3-0.8 part of the anti-dripping agent.

3. The polycarbonate alloy material according to claim 1, wherein the ratio of the shell thickness to the core diameter of the core-shell structured toughening agent is 1:(6-30).

4. The polycarbonate alloy material according to claim 1, wherein the silicon content of the core-shell structured toughening agent is 30-80 wt%.

5. The polycarbonate alloy material according to claim 1, wherein the flame retardant is a phosphorus based flame retardant.

6. The polycarbonate alloy material according to claim 1, wherein the acrylonitrile-butadiene-styrene copolymer is obtained by a bulk polymerization method.

7. The polycarbonate alloy material according to claim 1, wherein an average molecular weight of the polycarbonate is 21,000-33,650.

8. The polycarbonate alloy material according to claim 1, wherein the stabilizer is composed of a metal passivator, a hindered phenol antioxidant and a glycidyl methacrylate grafted styrene-acrylonitrile copolymer at a mass ratio of 1:(1-3):(1-8).

9. A method for preparing the polycarbonate alloy material according to any one of claims 1-8, comprising the following steps: mixing the respective components, conducting melt extrusion, and conducting granulation to obtain the polycarbonate alloy material.

10. Use of the polycarbonate alloy material according to any one of claims 1-8 in preparation of a photovoltaic energy product.
